Europäisches Patentamt

European Patent Office

Office européen des brevets

(19)

(11) **EP 0 645 894 B1**

(12) **FASCICULE DE BREVET EUROPEEN**

(45) Date de publication et mention
de la délivrance du brevet:
**02.06.1999 Bulletin 1999/22**

(51) Int Cl.⁶: **H03M 13/00**

(21) Numéro de dépôt: **94202233.6**

(22) Date de dépôt: **02.08.1994**

(54) **Système de transmission utilisant des modulations codées en blocs ou en treillis, récepteur et décodeur pour un tel système**

Übertragungssystem mit gitter- oder blockkodierter Modulation, Empfänger und Dekoder dafür

Transmission system using trellis or block coded modulation receiver and decoder therefor

(84) Etats contractants désignés:
**DE FR GB IT SE**

(30) Priorité: **04.08.1993 FR 9309610**

(43) Date de publication de la demande:
**29.03.1995 Bulletin 1995/13**

(73) Titulaire: **Koninklijke Philips Electronics N.V.
5621 BA Eindhoven (NL)**

(72) Inventeurs:
• **Moridi, Said, Société Civile S.P.I.D.
F-75008 Paris (FR)**
• **Martinez, Georges, Société Civile S.P.I.D.
F-75008 Paris (FR)**

(74) Mandataire: **Chaffraix, Jean et al
Société Civile S.P.I.D.
156, Boulevard Haussmann
75008 Paris (FR)**

(56) Documents cités:
• **IEEE TRANSACTIONS ON COMMUNICATIONS, vol.40, no.10, Octobre 1992, NEW YORK US pages 1581 - 1587 E. BIGLIERI 'Parallel Demodulation of Multidimensional Signals'**
• **ECRR 1991, 3RD CONFERENCE ON RADIO RELAY SYSTEMS, PARIS, 17-20 DEC 1991 pages 89 - 96 T. ROSTE ET AL. 'Modulation Methods for STM-1 with 29.65 MHz Channel Separation'**
• **ELECTRONICS AND COMMUNICATIONS IN JAPAN, vol.71, no.10, Octobre 1988, SILVER SPRING, MARYLAND, USA pages 114 - 123 M. MIYAKE ET AL. 'Performance of a Viterbi Decoder Using Simplified Digital Metric Calculation'**
• **IEEE JOURNAL ON SELECTED AREAS IN COMMUNICATION, vol.7, no.9, Décembre 1989, NEW YORK US pages 1369 - 1380 G. POTTIE ET AL. 'A Comparison of Reduced Complexity Decoding Algorithms for Trellis Codes'**

## Description

La présente invention concerne un système de transmission utilisant des modulations codées en blocs ou en treillis basées sur une constellation MAQ à 2N dimensions partitionnée en sous-ensembles, et comportant un émetteur et un récepteur qui est pourvu d'un décodeur afin de décoder lesdites modulations, ledit décodeur comportant en outre un module permettant de calculer une distance entre chaque échantillon reçu et le point qui en est le plus proche dans chaque sous-ensemble de la constellation à 2 dimensions.

Un tel décodeur permet de décoder une suite d'échantillons reçus d'un canal perturbé et résultant du codage convolutif ou du codage en blocs d'une suite d'informations à transmettre. Le comportement d'un codeur convolutif est décrit par un treillis dans lequel chaque transition entre deux états correspond à la transmission d'un point de la constellation qui est partitionnée en sous-ensembles de telle sorte que la distance entre deux points d'un sous-ensemble soit supérieure à la distance qui sépare deux points de la constellation d'origine.

L'algorithme de Viterbi est connu pour être une méthode optimale de décodage des codes convolutifs. Le principe d'un décodeur de Viterbi est décrit dans l'article "The Viterbi Algorithm" de G. David Forney paru le 3 mars 1973 dans la revue "Proceedings of the IEEE". Succinctement, on peut rappeler que le décodage au moyen d'un décodeur de Viterbi nécessite les trois étapes suivantes :

-    Pour chaque échantillon du signal reçu à 2 dimensions, il s'agit de trouver le point qui en est le plus proche dans chaque sous-ensemble de la constellation à 2 dimensions. Les métriques de branches associées à chaque échantillon reçu à 2N dimensions sont alors calculées à partir de ces N distances.
-    Il faut ensuite trouver la suite autorisée qui est la plus proche de la suite d'échantillons reçus, c'est-à-dire celle dont la métrique de chemin (qui est égale à la somme des métriques de branches qui composent ce chemin) est la plus faible.
-    Il faut enfin rechercher à l'aide du treillis la séquence de bits initiale correspondant à ce plus court chemin.

En principe, le calcul des métriques de branches implique l'utilisation de la distance euclidienne carrée. Ce calcul de carrés est complexe et nécessite un nombre élevé de bits pour sa représentation. Or pour certaines applications et en particulier dans le domaine des faisceaux hertziens où les débits sont très élevés, on ne dispose pas de mémoire suffisamment rapide. Il est donc nécessaire de simplifier le calcul des métriques de branches de façon à permettre des implantations sans mémoire de l'algorithme de Viterbi. Il est, par exemple, connu d'utiliser la distance de Manhattan qui remplace la somme de carrés par une somme de valeurs absolues comme l'indique le compte rendu, rédigé par Messieurs Terje Roste et Jonny Normann Skalvik, de la troisième ECRR (European Conference on Radio Relay systems) tenue à Paris du 17 au 20 décembre 1991. Toutefois, cette distance de Manhattan présente l'inconvénient suivant : lorsque les points reçus sont situés à la frontière de la constellation, les distances ainsi obtenues sont entachées d'erreurs.

Le but de la présente invention est de fournir un moyen simple de calculer les métriques de branches avec le minimum de bits nécessaires, sans approximation, autorisant ainsi des implantations sans mémoire du décodeur de Viterbi.

la distance $\tilde{\mu}$ utilisée est une distance relative donnée par une fonction $\Im$ des variables suivantes:

$$\tilde{\mu} = \Im\left[|\Delta_i|, sgn(\Delta_i), sgn(\mathrm{E}_i), |\mathrm{E}_i|\right]$$

où

-    l'indice i indique s'il s'agit de l'abscisse (i=x) ou de l'ordonnée (i=y) de la grandeur indicée,
-    $\Delta$ représente un vecteur déplacement entre deux points de la constellation,
-    E est l'erreur séparant le point reçu du point qui lui est le plus proche dans la constellation à deux dimensions,
-    sgn() indique la fonction signe.

Dans un mode de réalisation particulièrement avantageux, la distance relative $\tilde{\mu}$ utilisée est calculée à partir d'une expression du type :

$$\bar{\mu} = \sum_{i=x,y} |\Delta_i| \cdot (|\Delta_i| - sgn(\Delta_i) \cdot sgn(E_i) \cdot |E_i|)$$

Ainsi toute élévation au carré a été supprimée, sans introduire d'approximation, et remplacée par une multiplication par un entier naturel de faible valeur, très simple à mettre en oeuvre.

Lorsque la constellation d'origine est partitionnée en au plus huit sous-ensembles, la distance relative $\tilde{\mu}$ est obtenue par le calcul d'expressions du type:

$$(1 \pm |E_i|)$$

lorsque $|\Delta_i|$ est égal à 1, et par le calcul d'expressions du type

$$(2 \pm |E_i|)$$

suivi d'un décalage du résultat vers les bits de poids forts, lorsque $|\Delta_i|$ est égal à 2.

Ainsi, aucun multiplicateur ni même additionneur n'est alors nécessaire pour cette étape du calcul.

L'invention concerne également un récepteur pour un système de transmission tel que décrit ci-dessus, et un décodeur destiné à être utilisé dans un tel récepteur.

D'autres particularités, détails et avantages de l'invention seront mis en évidence par la description qui va suivre en regard des dessins annexés qui sont donnés à titre d'exemples non limitatifs, dans lesquels :

- la figure 1 représente les différentes partitions possibles d'une constellation MAQ16 à 2 dimensions,
- la figure 2 représente le quadrant positif des 4 constellations MAQ 16, 32, 64 et 128,
- la figure 3 représente un exemple de treillis à 8 états qui sera utilisé dans la suite de la description,
- la figure 4 est un schéma fonctionnel d'un exemple de décodeur destiné à être utilisé dans un récepteur d'un système de transmission selon l'invention,
- la figure 5 est un schéma fonctionnel d'un exemple de module de calcul d'un tel décodeur,
- la figure 6 est un schéma représentant différentes zones d'une constellation en croix et d'une constellation carrée, utilisées pour calculer des vecteurs de déplacement,
- la figure 7 représente un système de transmission selon l'invention.

Dans la suite de la description, on considère une constellation à 4 dimensions. Cette constellation A0×A0 est un ensemble de paires de points appartenant chacun à une constellation à 2 dimensions A0, (rappelons qu'un ensemble produit A×B est défini par le produit cartésien de l'ensemble A par l'ensemble B, c'est-à-dire que c'est l'ensemble des paires (x, y) où x∈A et y∈B) de telle sorte que la transmission d'un point de la constellation A0×A0 correspond à la transmission de deux points successifs de la constellation A0. Ainsi, la partition de la constellation A0×A0 est basée sur celle de la constellation A0.

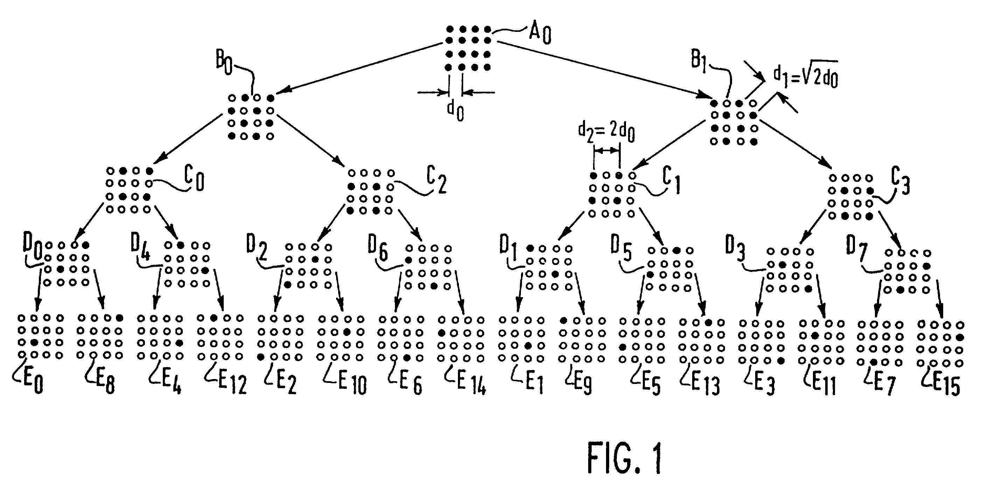

La figure 1 représente les différentes partitions possibles A, B, C, D et E d'une constellation MAQ16 à 2 dimensions. La constellation d'origine A0 est composée de points distants d'une distance $d_0$. Dans une première étape, elle est divisée en deux sous-ensembles B0 et B1, dont les points sont distants de la distance $d_1 = \sqrt{2} d_0$ . Puis dans une seconde étape, chaque sous-ensemble B0 et B1 est à son tour divisé en deux sous-ensembles C0 et C2 d'une part et C1 et C3 d'autre part de telle sorte que deux points d'un sous-ensemble C soient distants de la distance $d_2 = 2d_0$. Puis les sous-ensembles C sont eux-mêmes divisés chacun en deux sous-ensembles, formant ainsi une partition D composée de huit sous-ensembles de deux points distants de $d_1 = 2.\sqrt{2} d_0$. Enfin, chaque sous-ensemble D est lui-même divisé en deux sous-ensembles formant ainsi une partition E composée de 16 sous-ensembles comportant un unique point.

Dans la suite de la description, c'est la partition C qui est utilisée.

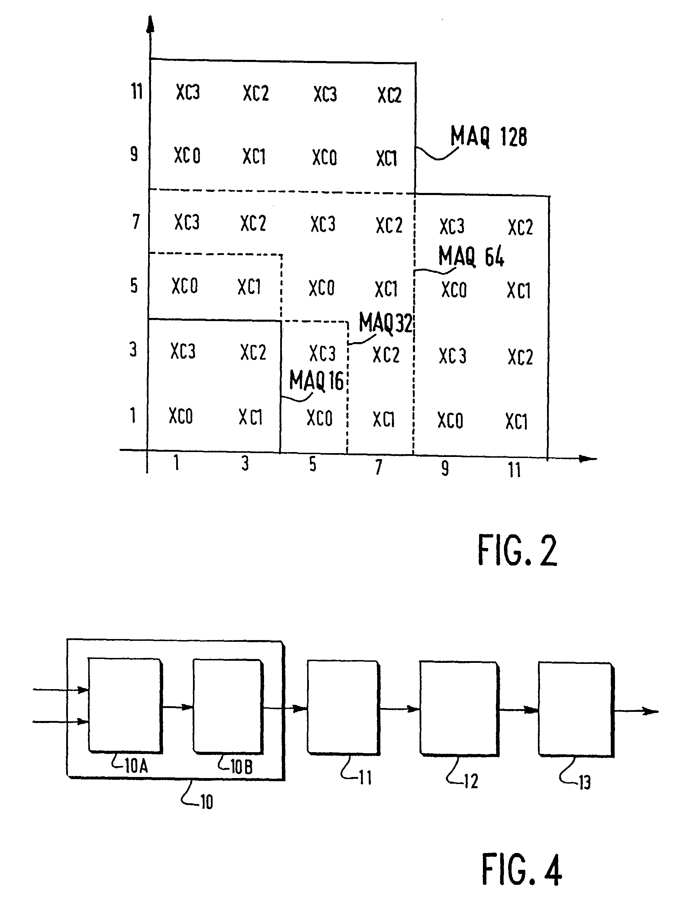

La figure 2 représente le quadrant positif des quatre constellations MAQ 16, 32, 64, 128, à deux dimensions, en indiquant auquel des quatre sous-ensembles C0, C1, C2 et C3 chacun des points appartient. Lorsque l'on considère la fenêtre constituée par les quatre points de la constellation MAQ16, les points de coordonnées (1, 1), (3, 1), (3, 3) et (1, 3) appartiennent respectivement aux sous-ensembles C0, C1, C2 et C3. En élargissant cette fenêtre d'une distance de $2d_0$ parallèlement à l'axe des abscisses ou à l'axe des ordonnées, on retrouve le même schéma pour les autres constellations. Les autres quadrants du plan sont facilement déductibles de celui-ci par rotation d'un multiple de $\pi/2$.

La partition de la constellation A0×A0 en 8 sous-ensembles numérotés L0 à L7 se déduit alors de la partition de la constellation A0 de la façon suivante :

$$L0 = C0 \times C0 \cup C2 \times C2,$$

$$L4 = C0 \times C2 \cup C2 \times C0,$$

$$L2 = C1 \times C1 \cup C3 \times C3,$$

$$L6 = C1 \times C3 \cup C3 \times C1,$$

$$L1 = C0 \times C3 \cup C2 \times C1,$$

$$L5 = C0 \times C1 \cup C2 \times C3,$$

$$L3 = C1 \times C0 \cup C3 \times C2,$$

$$L7 = C1 \times C2 \cup C3 \times C0,$$

où les symboles $\times$ et $\cup$ indiquent respectivement le produit cartésien et la réunion de deux ensembles.

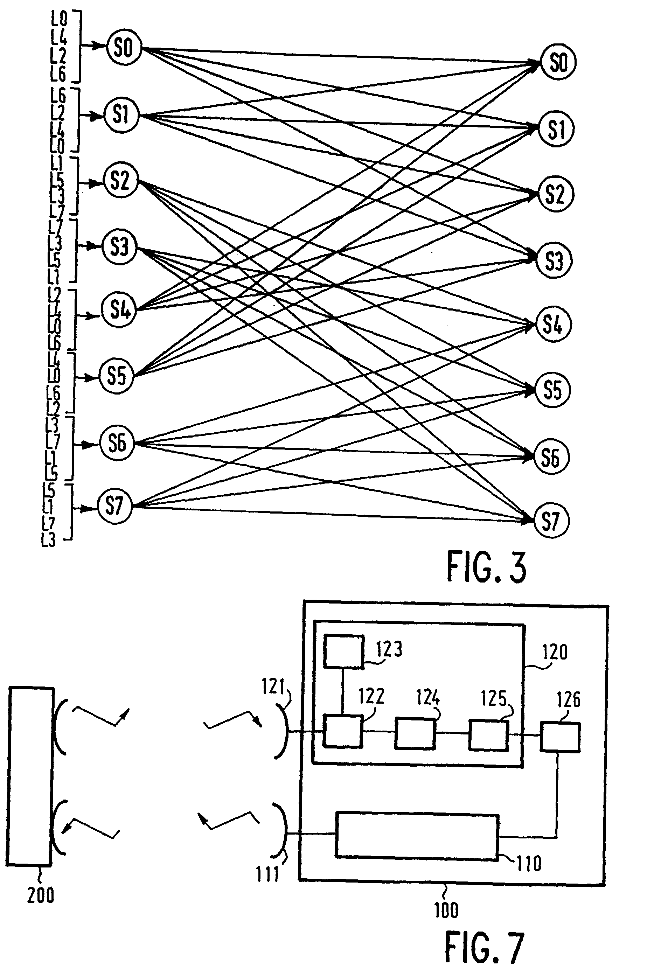

La figure 3 représente le treillis qui est utilisé dans la suite de la description. Il s'agit d'un treillis à 8 états, numérotés S0 à S7, qui autorise quatre transitions à partir de chaque état, représentées par des flèches sur la figure. Le passage d'un état à un autre correspond à la transmission d'un point à quatre dimensions appartenant à l'un de ces huit sous-ensembles L0 à L7. Ainsi, est-il possible à partir des états S0, S1, S4 et S5 d'atteindre les états S0, S1, S2 ou S3 en transmettant respectivement un point du sous-ensemble L0, L4, L2 ou L6; L6, L2, L4 ou L0; L2, L4, L0 ou L6; et L4, L0, L6 ou L2. De même, il est possible à partir des états S2, S3, S6 et S7 d'atteindre les états S4, S5, S6 ou S7 en transmettant respectivement un point du sous-ensemble L1, L5, L3 ou L7; L7, L3, L5 ou L1; L3, L7, L1 ou L5; et L5, L1, L7 ou L3.

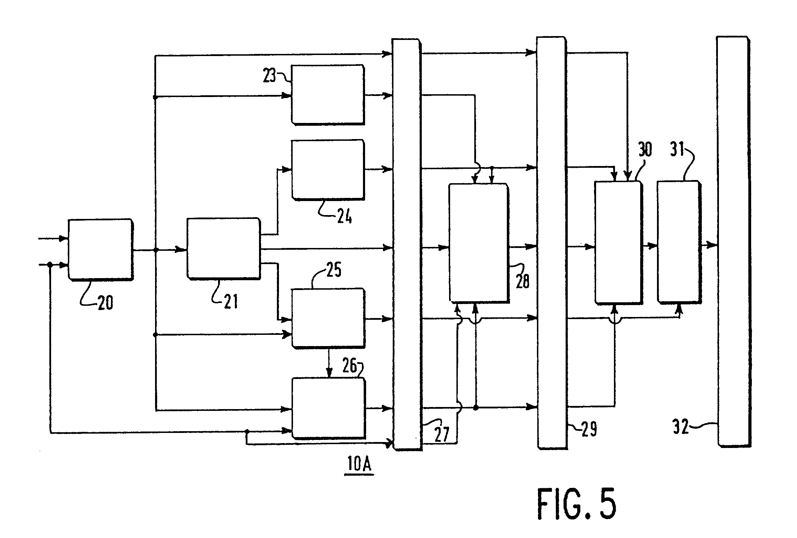

La figure 4 représente un schéma de principe d'un exemple de décodeur selon l'invention permettant de décoder de façon optimale un code convolutif décrit par un tel treillis. Ce décodeur comporte un premier bloc 10 composé de deux blocs 10A et 10B.

Le bloc 10A permet de calculer les quatre distances associées à chacun des deux points à 2 dimensions qui ont été reçus. Les deux ensembles de quatre distances qui en résultent sont combinés entre eux par le bloc 10B pour obtenir les 8 métriques de branches $\Lambda_0$ à $\Lambda_7$ associées au point à 4 dimensions correspondant.

Soit $\lambda_{n,j}$ la distance entre le $n^{ème}$ point reçu et le point qui en est le plus proche dans le sous-ensemble Cj (où n prend les valeurs 1 et 2 afin d'indiquer s'il s'agit du premier ou du second point reçu à 2 dimensions, et j prend les valeurs 0, 1, 2 et 3 indiquant respectivement qu'il s'agit de la distance relative au sous-ensemble C0, C1, C2 ou C3). Les 8 métriques de branches à 4 dimensions $\Lambda_0$ à $\Lambda_7$ sont alors obtenues d'après les formules suivantes :

$$\Lambda_0 = \min(\lambda_{1,0} + \lambda_{2,0} ; \lambda_{1,2} + \lambda_{2,2})$$

$$\Lambda_1 = \min(\lambda_{1,0} + \lambda_{2,3} ; \lambda_{1,2} + \lambda_{2,1})$$

$$\Lambda_2 = \min(\lambda_{1,1} + \lambda_{2,1} ; \lambda_{1,3} + \lambda_{2,3})$$

$$\Lambda_3 = \min(\lambda_{1,1} + \lambda_{2,0} ; \lambda_{1,3} + \lambda_{2,2})$$

$$\Lambda_4 = \min(\lambda_{1,2} + \lambda_{2,2} ; \lambda_{1,2} + \lambda_{2,0})$$

$$\Lambda_5 = \min(\lambda_{1,2} + \lambda_{2,1} ; \lambda_{1,2} + \lambda_{2,3})$$

$$\Lambda_6 = \min(\lambda_{1,3} + \lambda_{2,3} \; ; \; \lambda_{1,3} + \lambda_{2,1})$$

$$\Lambda_7 = \min(\lambda_{1,3} + \lambda_{2,2} \; ; \; \lambda_{1,3} + \lambda_{2,0}).$$

Le bloc 11 calcule ensuite, pour chacun des 8 états possibles, (définis par le treillis représenté figure 3) les quatre métriques de chemin correspondant aux transitions autorisées entre deux états. Seule la plus faible de ces métriques de chemin est retenue, ce qui revient à sélectionner, pour chacun des 8 états possibles à l'instant t+1, l'état à l'instant t dont il est le plus probablement issu. Par exemple, les quatre possibilités pour être dans l'état "0" à l'instant t+1 sont les suivantes :

- être dans l'état "0" à l'instant t et avoir transmis un point du sous-ensemble L0,
- être dans l'état "1" à l'instant t et avoir transmis un point du sous-ensemble L6,
- être dans l'état "4" à l'instant t et avoir transmis un point du sous-ensemble L2,
- être dans l'état "5" à l'instant t et avoir transmis un point du sous-ensemble L4.

Ainsi, la métrique de chemin retenue est la suivante :

$$\Gamma_0(t+1) = \min [\Gamma_0(t)+\Lambda_0 \; ; \; \Gamma_1(t)+\Lambda_6 \; ; \; \Gamma_4(t)+\Lambda_2 \; ; \; \Gamma_5(t)+\Lambda_4]$$

Puis le bloc 12 permet de sélectionner la plus courte des métriques de chemin parmi les 8 qui ont été calculées, et le bloc 13, enfin, recherche à l'aide du treillis la séquence de bits initiale qui correspond à ce plus court chemin, délivrant ainsi en sortie la séquence de bits la plus probablement émise par l'émetteur.

La figure 5 représente de façon détaillée un module 10A de calcul selon l'invention. Ce module comporte un bloc d'écrêtage 20 qui reçoit en entrée les coordonnées X et Y du point à 2 dimensions à traiter, ainsi qu'une variable Q codée sur 2 bits qui indique le format de la constellation utilisée (16, 32, 64 ou 128). Ce module d'écrêtage permet de ramener sur la frontière de la constellation les points reçus qui sont à l'extérieur, et délivre en sortie des coordonnées éventuellement modifiées X' et Y' correspondant à un point R de la constellation. Ces coordonnées sont fournies en entrées aux blocs 21, 23, 25 et 26. Le bloc 21 calcule les coordonnées du point $P_0$ de la constellation qui est le plus proche du point reçu R. Le résultat est transmis aux blocs 24 et 25 :

- le bloc 24 détermine à quel sous-ensemble Ci appartient ce point $P_0$ et en déduit la valeur de variables $I^k_X$ et $I^k_Y$ définies dans la suite de la description,
- et le bloc 25 calcule l'erreur E qui sépare le point reçu R du point le plus proche $P_0$.

Les blocs 23, 26 et 28 calculent des variables intermédiaires (respectivement $g_k$, $\delta_X$ et $\delta_Y$, $W_k$, qui sont définies dans la suite de la description) nécessaires au calcul de trois vecteurs déplacement $\Delta^k$ (où k=1, 2 ou 3) qui permettent, à partir du point $P_0$, de déterminer les trois autres voisins $P_k$ du point reçu R dans chacun des trois autres sous-ensembles de la constellation. Le bloc 26 reçoit en entrée, outre les coordonnées X' et Y', la variable Q et l'erreur E dont il détermine le signe.

Les données issues des blocs 20, 21, 23, 24, 25 et 26, ainsi que la variable Q, sont stockées dans un premier registre 27 à partir duquel, d'une part les données de sortie des blocs 21, 23, 24, 26 et la variable Q sont fournies en entrée au bloc 28, et d'autre part les données issues des blocs 20, 24, 25, 26 et 28 sont stockées dans un second registre 29. Les données issues des blocs 20, 24, 26 et 28, disponibles dans le registre 29, sont ensuite fournies à l'entrée du bloc 30 qui calcule les trois vecteurs de déplacement $\Delta^k$. La sortie du bloc 30 est connectée à l'entrée du bloc 31 qui reçoit par ailleurs l'erreur E, issue du bloc 25 et disponible dans le registre 29, et calcule les distances entre le point reçu et les quatre points les plus proches dans la constellation d'origine. Les résultats sont stockés dans un troisième registre 32.

Le principe du calcul des vecteurs déplacement $\Delta^k$ est détaillé ci-dessous. Le sous-ensemble Ci auquel appartient le point le plus proche $P_0$ étant déterminé, on recherche le déplacement qui permet d'obtenir le point $P_k$ le plus proche du point reçu R dans le sous-ensemble Cj (où j=0, 1, 2 ou 3 avec j≠i).

Pour cela, il est nécessaire de savoir quelle coordonnée (abscisse et/ou ordonnée) incrémenter en fonction des sous-ensembles source (Ci) et destination (Cj). Par exemple, pour passer du sous-ensemble source C0 aux sous-ensembles destinations C1, C2 et C3 respectivement, il faut respectivement incrémenter l'abscisse, l'abscisse et l'ordonnée, et l'ordonnée du point le plus proche $P_0$. Ainsi deux bits $I^k_X$ et $I^k_Y$ sont définis indiquant chacun si l'abscisse et l'ordonnée du point $P_0$ doivent être incrémentées ou non pour passer du point $P_0$ à chacun des trois points $P_k$. Ces

deux bits sont déterminés de la façon suivante par le bloc 24 :

$$I^k_X = b^1_s \oplus b^1_d \oplus b^0_s \oplus b^0_d$$

$$I^k_Y = b^1_s \oplus b^1_d$$

où $(b^1_s, b^0_s)$ et $(b^1_d, b^0_d)$ sont respectivement les valeurs binaires des indices (0, 1, 2 ou 3) du sous-ensemble source et du k$^{ème}$ sous-ensemble destination, et où le symbole $\oplus$ indique l'opération "OU EXCLUSIF".

Le calcul du vecteur de déplacement $\Delta^k$ nécessite alors de distinguer plusieurs cas selon la forme de la constellation et la zone de la constellation dans laquelle le point reçu R se situe. En effet, le principe général du calcul du vecteur déplacement $\Delta^k$ consiste à se déplacer dans le sens de l'erreur E. Toutefois deux exceptions doivent être prises en compte. D'une part, pour les points extrêmes de la constellation, le sens du déplacement doit être inversé de façon à ne pas sortir de la constellation. D'autre part, les constellations 32 et 128 ne sont pas carrées, et certains points virtuels pourraient être obtenus comme points les plus proches selon le principe général d'estimation du déplacement. Dans ce cas l'estimation première doit être modifiée.

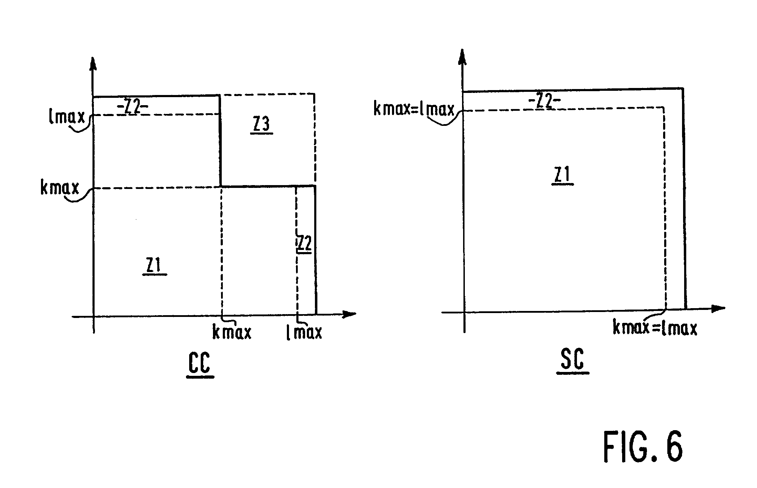

Les différents cas à prendre en compte sont représentés, pour le quadrant positif du plan, sur la figure 6. Dans le cas CC d'une constellation en croix, trois zones doivent être distinguées. La troisième zone Z3 est celle qui prolonge la constellation en croix pour en faire un carré. La seconde zone Z2 comporte tous les autres points situés à la frontière de ce carré. Le reste des points de la constellation constituent la première zone Z1. Ainsi, dans le cas SC d'une constellation carrée, la constellation n'est constituée que des deux premières zones Z1 et Z2.

D'autre part, deux nouvelles grandeurs sont définies sur cette figure : il s'agit de lmax qui est la limite supérieure des abscisses et des ordonnées des points de la constellation (la frontière de la constellation est donc déterminée par les droites d'équations X=lmax+1 et Y=lmax+1), et de kmax qui est la limite supérieure des abscisses et des ordonnées des points de la partie carrée de la constellation. Pour les constellations carrées, les grandeurs lmax et kmax sont donc égales.

Lorsque le point reçu R appartient à la première zone Z1, le déplacement $\Delta^k$ a pour sens celui de l'erreur E:

$$\Delta^k_X = I^k_X \cdot \text{sgn}(E_X)$$

$$\Delta^k_Y = I^k_Y \cdot \text{sgn}(E_Y)$$

Lorsque le point reçu R appartient à la seconde zone Z2, le sens du déplacement $\Delta^k$ est inversé par rapport au cas précédent:

$$\Delta^k_X = -I^k_X \cdot \text{sgn}(E_X)$$

$$\Delta^k_Y = -I^k_Y \cdot \text{sgn}(E_Y)$$

Ces deux cas peuvent donc être résumés par la formule suivante :

$$\Delta^k_X = h_X \cdot I^k_X \cdot \text{sgn}(E_X)$$

$$\Delta^k_Y = h_Y \cdot I^k_Y \cdot \text{sgn}(E_Y)$$

où $h_X$ et $h_Y$ sont des variables définies par les équations (I) suivantes :

$$h_x = \begin{cases} -1 & si \ |X| > lmax \\ 1 & sinon \end{cases}$$

$$h_Y = \begin{vmatrix} -1 & si & |Y| > lmax \\ 1 & sinon \end{vmatrix}$$

Le point de la constellation obtenu par un tel déplacement (I) est appelé $\hat{P}_k$ dans la suite de la description.

Toutefois, lorsque le point reçu R appartient à la troisième zone Z3, le déplacement obtenu d'après les équations (I) n'est qu'une première estimation qui, pour obtenir les points $P_k$, doit être modifiée d'après les équations (II) suivantes :

$$\Delta_X^k = I_X^k . h_X . sgn(E_X) - 2 . sgn(X) . \bar{g}_k . f(\hat{P}_k)$$

$$\Delta_Y^k = I_Y^k . h_Y . sgn(E_Y) - 2 . sgn(Y) . \bar{g}_k . f(\hat{P}_k)$$

où la fonction f et les variables $g_k$ sont définies de la façon suivante :

$$f(\hat{P}_k) = \begin{vmatrix} 1 & si & \hat{P}_k \in Z3 \\ 0 & sinon, \end{vmatrix}$$

$$g_0 = \begin{vmatrix} 1 & si & |X+1| > |Y+1| \\ 0 & sinon \end{vmatrix}$$

$$g_1 = \begin{vmatrix} 1 & si & |X-1| > |Y+1| \\ 0 & sinon \end{vmatrix}$$

$$g_2 = \begin{vmatrix} 1 & si & |X-1| > |Y-1| \\ 0 & sinon \end{vmatrix}$$

$$g_3 = \begin{vmatrix} 1 & si & |X+1| > |Y-1| \\ 0 & sinon \end{vmatrix}$$

Ces variables $g_k$ indiquent la position du point reçu R par rapport aux axes de symétrie des sous-ensembles à deux dimensions C0, C1, C2 et C3, permettant ainsi de déterminer quel est le point le plus proche de R parmi les deux points possibles (points obtenus par déplacement horizontal ou par déplacement vertical par rapport à la première estimation $\hat{P}_k$). Le facteur sgn(X) ou sgn(Y) utilisé dans la formule précédente permet de la généraliser aux quatres quadrants du plan.

L'expression générale du déplacement $\Delta^k$ en format binaire est la suivante :

$$\Delta_X^k = I_X^k . (1-2\delta_X) - 2W_X^k . (1-2S_X)$$

$$\Delta^k_Y = I^k_Y.(1-2\delta_Y) - 2W^k_Y.(1-2S_Y)$$

avec

$$1-2S_X = sgn(X) \text{ et } 1-2S_Y = sgn(Y)$$
$$1-2\delta_X = h_X.sgn(E_X) \text{ et } 1-2\delta_Y = h_Y.sgn(E_Y)$$
$$W^k_X = f(\hat{P}_k).\overline{g_k} \text{ et } W^k_Y = f(\hat{P}_k).g_k$$

Elle permet de coder le déplacement $\Delta^k$ sur 3 bits $\Delta2$, $\Delta1$ et $\Delta0$ obtenus comme indiqué ci-dessous :

$$\Delta2 = W.\overline{S} + I.\overline{W}.\delta$$

$$\Delta1 = \overline{I}.W + I.(W \oplus \delta)$$

$$\Delta0 = I$$

$\delta$ est calculé par le bloc 26 à partir des coordonnées du point reçu R, de la valeur de Imax pour la constellation utilisée et de l'erreur E. Et W est calculé par le bloc 28 qui, pour les constellations en croix, évalue au préalable la valeur de $f(\hat{P}_k)$ de la façon suivante :
soient (b3, b2, b1, b0) la valeur binaire d'une composante du point $P_0$, la valeur de $f(\hat{P}_k)$ pour une constellation MAQ 32 est donnée par le calcul suivant :

$$f_{32}(\hat{P}_k) = \overline{I}.(\beta_2 + \beta_1) + I.[\hat{\delta}.(\beta_2 + \beta_1 + \beta_0) + \overline{\hat{\delta}}.(\beta_2 + \overline{\beta_2}.\beta_1.\beta_0)]$$

et pour une constellation MAQ 128, elle est donnée par le calcul suivant :

$$f_{128}(\hat{P}_k) = \overline{I}.\beta_2 + I.[\hat{\delta}.(\beta_2 + \overline{\beta_2}.\beta_1.\beta_0) + \overline{\hat{\delta}}.\beta_2.(\beta_1 + \beta_0)]$$

avec

$$\beta_2 = b3 \oplus b2$$

$$\beta_1 = b3 \oplus b1$$

$$\beta_0 = b3 \oplus b0$$

$$\hat{\delta} = b_3 \oplus \overline{\delta}$$

L'étape suivante, réalisée par le bloc 31 consiste à calculer les quatre distances à l'aide de ces vecteurs déplacement $\Delta^k$. D'après les paragraphes précédents, les points les plus proches sont :

$$P_k = P_0 + 2(\Delta^k_X, \Delta^k_Y)$$

où $\Delta^k_X$ et $\Delta^k_Y$ peuvent prendre les valeurs 0, $\pm1$, $\pm2$ dans le cas d'une partition C.
La distance euclidienne $\mu_k$ entre le point reçu R et le point $P_k$ du sous-ensemble Cj s'écrit donc :

$$\mu_k = |R - P_k|^2$$

$$\mu_k = |R - P_0 - 2(\Delta^k{}_X, \Delta^k{}_Y)|^2$$

$$\mu_k = |(E_X, E_Y) - 2(\Delta^k{}_X, \Delta^k{}_Y)|^2$$

$$\mu_k = E_X{}^2 + E_Y{}^2 + 4\tilde{\mu}_k$$

avec

$$\tilde{\mu}_k = (\Delta^k{}_X)^2 + (\Delta^k{}_Y)^2 - (\Delta^k{}_X \cdot E_X + \Delta^k{}_Y \cdot E_Y).$$

C'est cette distance relative $\tilde{\mu}_k$ qui est utilisée par le module de calcul selon l'invention. Elle peut également s'écrire sous la forme suivante :

$$\tilde{\mu}_k = |\Delta^k{}_X| \cdot [\,|\Delta^k{}_X| - sgn(\Delta^k{}_X) \cdot sgn(E_X) \cdot |E_X|\,]$$
$$+ |\Delta^k{}_Y| \cdot [\,|\Delta^k{}_Y| - sgn(\Delta^k{}_Y) \cdot sgn(E_Y) \cdot |E_Y|\,].$$

ce qui permet de distinguer deux cas :

si $|\Delta^k| = 1$ alors il suffit de calculer le terme $1\pm|E|$,
si $|\Delta^k| = 2$ alors il suffit de calculer le terme $2\pm|E|$

puis d'opérer un décalage des bits vers les poids forts.
Aucun multiplicateur ni même additionneur n'est donc nécessaire pour réaliser ces opérations.
Dans un exemple pratique de mise en oeuvre d'un décodeur selon l'invention, l'erreur $E_X$, $E_Y$ a été codée sur trois bits, ayant ainsi pour valeur extrême $\pm 7/8$, et une constellation carrée (MAQ 16, 64 ...) a été utilisée. Les déplacements $\Delta^k$ ne peuvent donc prendre que les valeurs 0 et $\pm 1$, la valeur $\pm 2$ n'étant obtenue que pour les points virtuels d'une constellation en croix. La distance relative $\tilde{\mu}_k$ vérifie alors l'inéquation suivante :

$$0 \leq \tilde{\mu}_k \leq 1 + 1 + 7/8 + 7/8 < 31/8$$

et elle est donc codée sur 5 bits, alors qu'avec les mêmes paramètres, la distance euclidienne carrée est codée sur 9 bits ($\mu \leq 265/16 < 512/16$).
La complexité d'un tel décodeur, qui dépend fortement du nombre de bits nécessaires à la représentation des métriques de chemin et donc des métriques de branches, est donc réduite, sans détériorer la précision du calcul, ce qui permet de maintenir les performances du décodeur.
La figure 7 donne un schéma de principe d'un système de transmission selon l'invention. Un tel système est composé de deux émetteur/récepteurs 100 et 200 identiques, seul le circuit émetteur/récepteur 100 étant détaillé sur la figure. Ce circuit émetteur/récepteur 100 est composé d'un émetteur 110 et d'un récepteur 120. Le récepteur 120 comporte une antenne 121 de réception, reliée à une première entrée d'un circuit mélangeur 122 dont une seconde entrée est reliée à la sortie d'un oscillateur local 123. La sortie du circuit mélangeur est relié à un circuit de démodulation 124 lui-même relié à un décodeur 125 tel que décrit à la figure 4. Les informations reçues, disponibles à la sortie de ce décodeur 125, sont délivrées à un utilisateur 126.
Cet utilisateur 126 est d'autre part relié à l'émetteur 110 auquel il fournit des informations à transmettre, l'émetteur 110 étant lui-même relié à une antenne 111 d'émission.
Il va de soi que des variantes peuvent être apportées aux modes de réalisation qui viennent d'être décrits, notamment par substitution de moyens techniques équivalents sans que l'on sorte pour cela du cadre de la présente invention. En particulier, la partition choisie, la dimension de la constellation d'origine, le treillis utilisés pourraient être différents. Dans le cas où la partition choisie n'est pas la partition C, le calcul des déplacements $\Delta^k_X$ et $\Delta^k_Y$ devra être modifié en conséquence, et ils pourront pour des partitions supérieures prendre les valeurs entières supérieures à 2 en valeur absolue, mais qui demeurent faibles de telle sorte que cela n'a pas de conséquence sur la complexité du décodeur.

**Revendications**

1. Système de transmission utilisant des modulations codées en blocs ou en treillis basées sur une constellation MAQ à 2N dimensions partitionnées en sous-ensembles, et comportant un émetteur (110) et un récepteur (120) qui est pourvu d'un décodeur (125) afin de décoder lesdites modulations, ledit décodeur comportant en outre un module (10A) permettant de calculer une distance entre chaque échantillon reçu et le point qui en est le plus proche dans chaque sous-ensemble de la constellation à 2 dimensions, caractérisé en ce que la distance $\tilde{\mu}$ utilisée est une distance relative donnée par une fonction $\Im$ des variables suivantes :

$$\tilde{\mu} = \Im\big[|\Delta_i|, sgn(\Delta_i), sgn(E_i), |E_i|\big]$$

où

- l'indice i indique s'il s'agit de l'abscisse (i=x) ou de l'ordonnée (i=y) de la grandeur indicée,
- $\Delta$ représente un vecteur déplacement entre deux points de la constellation,
- E est l'erreur séparant le point reçu du point qui lui est le plus proche dans la constellation à 2 dimensions,
- sgn() indique la fonction signe.

2. Système de transmission selon la revendication 1, caractérisé en ce que la distance relative $\tilde{\mu}$ utilisée est calculée à partir d'une expression du type :

$$\tilde{\mu} = \sum_{i=x,y} |\Delta_i| . \left( |\Delta_i| - sign(\Delta_i).sgn(E_i).|E_i| \right)$$

3. Système de transmission selon l'une des revendications 1 ou 2, caractérisé en ce que, lorsque la constellation d'origine est partitionnée en, au plus, huit sous-ensembles, la distance relative $\tilde{\mu}$ est obtenue par le calcul d'expressions du type :

$$(1 \pm |E_i|)$$

lorsque $|\Delta_i|$ est égal à 1, et par le calcul d'expressions du type

$$(2 \pm |E_i|)$$

suivi d'un décalage du résultat vers les bits de poids forts, lorsque $|\Delta_i|$ est égal à 2.

4. Système de transmission selon l'une des revendications 1 à 4, caractérisé en ce que chacune des coordonnées de l'erreur E est codée sur trois bits.

5. Décodeur pour modulations codées en blocs ou en treillis basées sur une constellation MAQ à 2N dimensions partitionnée en sous-ensembles, ledit décodeur comportant en outre un module (10A) permettant de calculer une distance entre chaque échantillon reçu et le point qui en est le plus proche dans chaque sous-ensemble de la constellation à 2 dimensions,
caractérisé en ce que la distance $\tilde{\mu}$ utilisée est une distance relative donnée par une fonction $\Im$ des variables

suivantes :

$$\widetilde{\mu} = \Im\left[\left|\Delta_i\right|, sgn(\Delta_i), sgn(E_i), \left|E_i\right|\right]$$

où

- l'indice i indique s'il s'agit de l'abscisse (i=x) ou de l'ordonnée (i=y) de la grandeur indicée,
- Δ représente un vecteur déplacement entre deux points de la constellation,
- E est l'erreur séparant le point reçu du point qui lui est le plus proche dans la constellation à 2 dimensions,
- sgn() indique la fonction signe.

6. Décodeur selon la revendication 5, caractérisé en ce que la distance relative $\widetilde{\mu}$ utilisée est calculée à partir d'une expression du type :

$$\widetilde{\mu} = \sum_{i=x,y} \left|\Delta_i\right|.\left(\left|\Delta_i\right| - sign(\Delta_i).sgn(E_i).\left|E_i\right|\right)$$

7. Récepteur, caractérisé en ce qu'il comporte un décodeur selon l'une des revendications 5 ou 6.

8. Procédé de décodage pour modulations codées en blocs ou en treillis basées sur une constellation MAQ à 2N dimensions partitionnée en sous-ensembles, ledit procédé de décodage comportant en outre une étape de calcul d'une distance entre chaque échantillon reçu et le point qui en est le plus proche dans chaque sous-ensemble de la constellation à 2 dimensions,
caractérisé en ce que la distance $\widetilde{\mu}$ utilisée est une distance relative donnée par une fonction $\Im$ des variables suivantes :

$$\widetilde{\mu} = \Im\left[\left|\Delta_i\right|, sgn(\Delta_i), sgn(E_i), \left|E_i\right|\right]$$

où

- l'indice i indique s'il s'agit de l'abscisse (i=x) ou de l'ordonnée (i=y) de la grandeur indicée,
- Δ représente un vecteur déplacement entre deux points de la constellation,
- E est l'erreur séparant le point reçu du point qui lui est le plus proche dans la constellation à 2 dimensions,
- sgn() indique la fonction signe.

9. Procédé de décodage selon la revendication 8 caractérisé en ce que distance relative $\widetilde{\mu}$ utilisée est calculée à partir d'une expression du type :

$$\widetilde{\mu} = \sum_{i=x,y} \left|\Delta_i\right|.\left(\left|\Delta_i\right| - sign(\Delta_i).sgn(E_i).\left|E_i\right|\right).$$

**Patentansprüche**

1. Ein Übertragungssystem mit gitter- oder blockkodierten Modulationen, gründend auf einer Konstellation MAQ mit 2N Dimensionen, in Unterensembles aufgeteilt, und das einen Sender (110) und Empfänger (120) enthält, der mit einem Dekodierer (125) versehen ist, um die besagten Modulationen zu dekodieren, wobei der besagte Dekodierer zudem ein Modul (10A) enthält, das die Berechnung ermöglicht einer Distanz zwischen jedem erhaltenen Muster und dem Punkt, der davon in jedem Unterensemble der Konstellation mit 2 Dimensionen am nächsten ist, dadurch gekennzeichnet, daß die verwendete Distanz $\widetilde{\mu}$ eine relative Distanz ist, gegeben durch eine Funktion $\Im$ folgender

Variablen:

$$\widetilde{\mu} = \Im\left[\left|\Delta_i\right|\mathrm{sgn}(\Delta_i),\mathrm{sgn}(E_i),\left|E_i\right|\right]$$

wobei

- der Index i anzeigt, ob es sich um die Abszisse (i=x) oder die Ordinate (i=y) der indizierten Größe handelt,
- $\Delta$ einen Versetzungsvektor zwischen zwei Punkten der Konstellation darstellt,
- E der Fehler ist, der den empfangenen Punkt von dem Punkt trennt der ihm in der Konstellation mit zwei Dimensionen am nächsten ist,
- sgn() die Funktion Zeichen anzeigt.

2.  Übertragungssystem nach Anspruch 1, dadurch gekennzeichnet, daß die verwendete relative Distanz $\widetilde{\mu}$ berechnet wird anhand eines Ausdrucks des Typs:

$$\widetilde{\mu} = \sum_{i=x,y}\left|\Delta_i\right|\cdot\left(\left|\Delta_i\right| - \mathrm{sgn}(\Delta_i)\cdot\mathrm{sgn}(E_i)\cdot\left|E_i\right|\right)$$

3.  Übertragungssystem nach einem der Ansprüche 1 oder 2, dadurch gekennzeichnet, daß wenn die ursprüngliche Konstellation in höchstens acht Unterensembles aufgeteilt ist, die relative Distanz $\widetilde{\mu}$ mit der Berechnung von Ausdrücken dieses Typs erhalten wird:

$$(1 \pm |E_i|)$$

wenn $|\Delta_i|$ gleich 1 ist, und durch die Berechnung von Ausdrücken des Typs

$$(2 \pm |E_i|)$$

gefolgt von einer Versetzung des Ergebnisses zu den Bits hohen Wertes, wenn $|\Delta_i|$ gleich 2 ist.

4.  Übertragungssystem nach einem der Ansprüche 1 oder 2, dadurch gekennzeichnet, daß jede der Fehlerkoordinaten E über drei Bits kodiert ist.

5.  Dekodierer für gitter- oder blockkodierte Modulationen, gründend auf einer Konstellation MAQ mit 2N Dimensionen, in Unterensembles aufgeteilt, wobei der besagte Dekodierer zudem ein Modul (10A) enthält, das die Berechnung ermöglicht einer Distanz zwischen jedem erhaltenen Muster und dem Punkt, der davon in jedem Unterensemble der Konstellation mit 2 Dimensionen am nächsten ist, dadurch gekennzeichnet, daß die verwendete Distanz $\widetilde{\mu}$ eine relative Distanz ist, gegeben durch eine Funktion $\Im$ folgender Variablen:

$$\widetilde{\mu} = \Im\left[\left|\Delta_i\right|\mathrm{sgn}(\Delta_i),\mathrm{sgn}(E_i),\left|E_i\right|\right]$$

wobei

- der Index anzeigt, ob es sich um die Abszisse (i=x) oder die Ordinate (i=y) der indizierten Größe handelt,
- $\Delta$ einen Versetzungsvektor zwischen zwei Punkten der Konstellation darstellt,
- E der Fehler ist, der den empfangenen Punkt von dem Punkt trennt der ihm in der Konstellation mit zwei Dimensionen am nächsten ist,
- sgn() die Funktion Zeichen anzeigt.

6.  Dekodierer nach Anspruch 5, dadurch gekennzeichnet, daß die verwendete relative Distanz $\widetilde{\mu}$ berechnet wird anhand eines Ausdrucks des Typs:

$$\widetilde{\mu} = \sum_{i=x,y} |\Delta_i| \cdot \left( |\Delta_i| - \operatorname{sgn}(\Delta_i) \cdot \operatorname{sgn}(E_i) \cdot |E_i| \right)$$

7. Empfänger, dadurch gekennzeichnet, daß er einen Dekodierer nach einem der Ansprüche 5 oder 6 enthält.

8. Dekodierverfahren für gitter- oder blockkodierte Modulationen, gründend auf einer Konstellation MAQ mit 2N Dimensionen, in Unterensembles aufgeteilt, wobei das besagte Dekodierverfahren zudem einen Rechenschritt enthält, der die Berechnung ermöglicht einer Distanz zwischen jedem erhaltenen Muster und dem Punkt, der davon in jedem Unterensemble der Konstellation mit 2 Dimensionen am nächsten ist, dadurch gekennzeichnet, daß die verwendete Distanz $\widetilde{\mu}$ eine relative Distanz ist, gegeben durch eine Funktion $\Im$ folgender Variablen:

$$\widetilde{\mu} = \Im \left[ |\Delta_i| \operatorname{sgn}(\Delta_i), \operatorname{sgn}(E_i), |E_i| \right]$$

wobei

- der Index i anzeigt, ob es sich um die Abszisse (i=x) oder die Ordinate (i=y) der indizierten Größe handelt,
- $\Delta$ einen Versetzungsvektor zwischen zwei Punkten der Konstellation darstellt,
- E der Fehler ist, der den empfangenen Punkt von dem Punkt trennt der ihm in der Konstellation mit zwei Dimensionen am nächsten ist,
- sgn() die Funktion Zeichen anzeigt.

9. Dekodierverfahren nach Anspruch 8, dadurch gekennzeichnet, daß die verwendete relative Distanz $\widetilde{\mu}$ berechnet wird anhand eines Ausdrucks des Typs:

$$\widetilde{\mu} = \Im \left[ |\Delta_i| \operatorname{sgn}(\Delta_i), \operatorname{sgn}(E_i), |E_i| \right]$$

## Claims

1. A transmission system using block-coded or trellis-coded modulations based on a 2N-dimensional QAM constellation divided into sub-sets, and comprising a transmitter (110) and a receiver (120) which is provided with a decoder (125) for decoding said modulations, said decoder also comprising a module (10A) allowing calculation of a distance between each received sample and the point which is closest thereto in each sub-set of the two-dimensional constellation, characterized in that the distance $\tilde{\mu}$ used is a relative distance given by a function $\mathscr{F}$ of the following variables:

$$\tilde{\mu} = \mathscr{F} \left[ |\Delta_i|, \operatorname{sgn}(\Delta_i), \operatorname{sgn}(E_i), |E_i| \right]$$

in which

- the index i indicates that this is the abscissa (i=x) or the ordinate (i=y) of the quantity indicated,
- $\Delta$ represents a displacement vector between two points of the constellation,
- E is the error separating the point received from the point which is closest thereto in the two-dimensional constellation,
- sgn() indicates the sign function.

2. A transmission system as claimed in claim 1, characterized in that the relative distance $\tilde{\mu}$ used is calculated from an expression of the type:

$$\tilde{\mu} = \sum_{i=x,y} \mid \Delta_i \mid \cdot \left( \mid \Delta_i \mid - sgn(\Delta_i) \cdot sgn(E_i) \cdot \mid E_i \mid \right)$$

3. A transmission system as claimed in any one of claim 1 or 2, characterized in that, when the original constellation is subdivided into at most eight sub-sets, the relative distance $\tilde{\mu}$ is obtained through calculation of expressions of the type:

$$(i \pm |E_i|)$$

when $|\Delta_i|$ is equal to 1, and through calculation of expressions of the type

$$(2 \pm |E_i|)$$

followed by a shifting of the result towards the most significant bits when $|\Delta_i|$ is equal to 2.

4. A transmission system as claimed in any one of claims 1 to 4, characterized in that each of the coordinates of the error E is coded in three bits.

5. A decoder for block-coded or trellis-coded modulations based on a 2N-dimensional QAM constellation divided into sub-sets, said decoder also comprising a module (10A) allowing calculation of a distance between each received sample and the point which is closest thereto in each sub-set of the two-dimensional constellation, characterized in that the distance $\tilde{\mu}$ used is a relative distance given by a function $\mathscr{F}$ of the following variables:

$$\tilde{\mu} = \mathscr{F} \left[ \left| \Delta_i \right|, \; sgn(\Delta_i), \; sgn(E_i), \; \left| E_i \right| \right]$$

in which

- the index i indicates that this is the abscissa (i=x) or the ordinate (i=y) of the quantity indicated,
- $\Delta$ represents a displacement vector between two points of the constellation,
- E is the error separating the point received from the point which is closest thereto in the two-dimensional constellation,
- sgn() indicates the sign function.

6. A decoder as claimed in claim 5, characterized in that the relative distance $\tilde{\mu}$ used is calculated from an expression of the type:

$$\tilde{\mu} = \sum_{i=x,y} \mid \Delta_i \mid \cdot \left( \mid \Delta_i \mid - sgn(\Delta_i) \cdot sgn(E_i) \cdot \mid E_i \mid \right)$$

7. A receiver, characterized in that it comprises a decoder as claimed in any one of claim 5 or 6.

8. A decoding method for block-coded or trellis-coded modulations based on a 2N-dimensional QAM constellation divided into sub-sets, said decoding method also comprising a step of calculating a distance between each received sample and the point which is closest thereto in each sub-set of the two-dimensional constellation, characterized in that the distance $\tilde{\mu}$ used is a relative distance given by a function $\mathscr{F}$ of the following variables:

$$\tilde{\mu} = \mathscr{F} \left[ \left| \Delta_i \right|, \; sgn(\Delta_i), \; sgn(E_i), \; \left| E_i \right| \right]$$

in which

- the index i indicates that this is the abscissa (i=x) or the ordinate (i=y) of the quantity indicated,
- Δ represents a displacement vector between two points of the constellation,
- E is the error separating the point received from the point which is closest thereto in the two-dimensional constellation,
- sgn() indicates the sign function.

9.  A decoding method as claimed in claim 8, characterized in that the relative distance $\tilde{\mu}$ used is calculated from an expression of the type:

$$\tilde{\mu} = \sum_{i=x,y} \mid \Delta_i \mid \cdot (\mid \Delta_i \mid - sgn(\Delta_i) \cdot sgn(E_i) \cdot \mid E_i \mid)$$

FIG. 1

EP 0 645 894 B1

FIG. 2

FIG. 4

17

FIG. 3

FIG. 7

FIG. 5

FIG. 6